# EUROPEAN PATENT APPLICATION

(11) **EP 0 887 858 A2**
(43) Date of publication of application: **30.12.1998**
(21) Application number: 98110309.6
(22) Date of filing: 05.06.1998
(51) Int. Cl.: H01L 23/525

(54) **Protection layer for laser blown fuses in semiconductor devices**

(30) Priority: 26.06.1997 US 882866
(71) Applicant: SIEMENS AKTIENGESELLSCHAFT, 80333 München (DE)
(72) Inventor: Gall, Martin, South Burlington, VT 05403 (US); Mitwalsky, Alexander R., Richmond, VA 23233 (US); Dinkel, Bettina, Poughkeepsie, NY 12601 (US)
(74) Representative: Patentanwälte Westphal, Buchner, Mussgnug Neunert, Göhring

(57) **Abstract**

A protective layer protects a fuse in an integrated circuit from incidental damage during laser deleting of an adjacent fuse. This approach allows very small fuse pitch applications, e.g., for redundancy activation.

## Description

### BACKGROUND

### 1. Technical Field

This disclosure relates generally to integrated circuits that include a plurality of fuses wherein at least one of the fuses is intentionally blown, e.g., by application of laser energy. More specifically, a fuse in the integrated circuits described herein is protected from incidental damage during laser deleting of an adjacent fuse in the device. Methods for producing such integrated circuits are also described.

### 2. Background of Related Art

Integrated circuits consist of many, sometime thousands, of individual elements jointed together on a chip by electrically conductive interconnects. It has been found that the ability to alter interconnects on a chip after standard processing is completed provides great improvement in a chip yield (number of working chips) and chip customization (modifying a chip to perform a specific function). A technique widely practiced in the industry involves using light from a laser to vaporize (blow) segments of interconnects (referred to as fuses), thereby forming an "open" that eliminates the electrical connection originally provided by the interconnect. Usually, these fuses are connected to redundancy circuits, replacing defect word- and/or bit-lines with redundant lines (redundancy activation).

Although this technique of laser deleting has been widely used in an attempt to improve functional yields, fuse blow yield and fuse reliability have been problematic in conventional devices made using conventional processes, particularly for small fuse pitch applications. Specifically, application of laser energy to a fuse in conventional devices is likely to result in damage to structures adjacent the fuse being blown. This is particularly true where the adjacent structure is another fuse that is equally susceptible to being blown as the target fuse. Since the use of a plurality of fuses side-by-side is not uncommon, unintentional blow of an adjacent fuse is a recognized problem by those in the art.

One approach to solving this problem has been to use large spacings between the fuses and thereby avoid unintentional exposure of fuses next to the target fuse to the laser energy. Such large spacing, however, is not compatible with present trends in increasing the density of integrated circuits on a chip.

It would be desirable to provide a device that incorporates at least two fuses side by side while not requiring large spacing between the fuses yet providing for easy, selective blowing of one fuse without damage to any adjacent fuses.

### SUMMARY OF THE INVENTION

It has now been discovered that a target fuse can be blown without damaging an adjacent fuse by a protective layer formed over at least a first portion of the adjacent fuse. Preferably, a second portion of the adjacent fuse remains unprotected to allow the adjacent fuse to be blown, if desired.

A process for making an improved integrated circuit has also been discovered. In the process, at least two fuses, a first fuse and a second fuse, are formed adjacent each other. Then, a protective layer is formed over a portion of the second fuse. In a particularly useful embodiment, an intermediate layer is formed between the fuse and the protective layer.

The methods and devices described herein advantageously permit the use of decreased fuse pitch and affords easier processing due to reduced criticality in laser alignment.

### BRIEF DESCRIPTION OF THE DRAWINGS

FIG. 1 is a partial schematic, top plan view of a device in accordance with this disclosure; and
FIG. 2 is a schematic, cross-sectional view of a particularly useful device in accordance with this disclosure.

### DETAILED DESCRIPTION OF THE PREFERRED EMBODIMENTS

An integrated circuit device in accordance with this disclosure includes a plurality of interconnects formed adjacent each other on a substrate, with a protective layer formed over at least a portion of one of the interconnects. The protective layer prevents damage of the covered portion of the interconnect when an adjacent interconnect is exposed to laser energy.

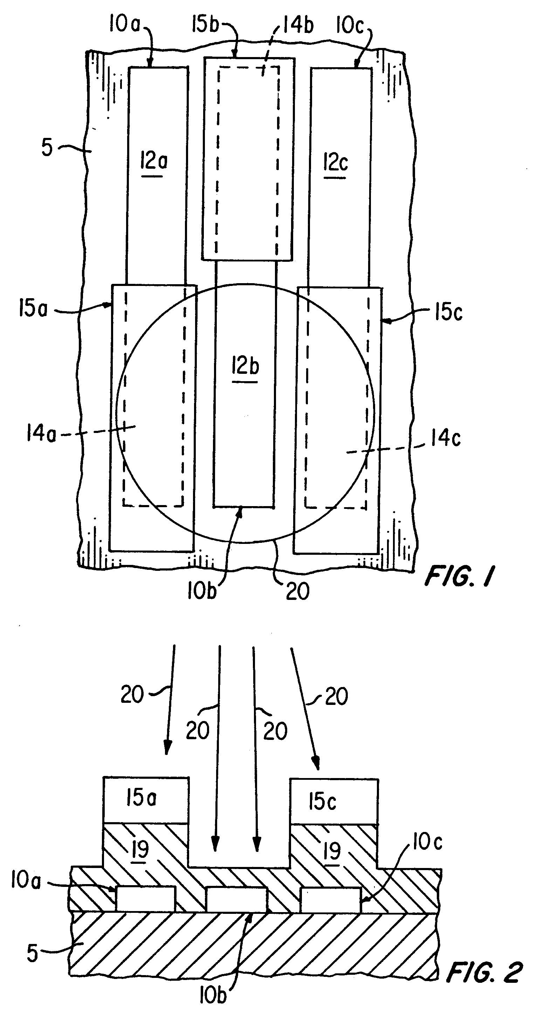

As seen in the embodiment shown in FIG. 1, a plurality of interconnects such as, for example fuses 10a, 10b, and 10c are formed on substrate 5. While fuses 10a, b, and c are shown in parallel juxtaposition, it should be understood that adjacent fuses can be at other orientations.

Fuses 10a, b and c can be made from any of the materials known to be useful in forming interconnects. Suitable materials for forming the fuses include aluminum, copper, polysilicon, silicide, Al-Si, Al-Cu, Al-Si-Cu or any high conductive metal or alloy. Techniques for depositing fuses from these materials are within the purview of one skilled in the art. The fuses should be as thin as possible. typically the thickness of the fuses can range from about 0.1µm to about 1µm, preferably from about 0.1µm to about 0.5µm. The dimensions of the fuses will typically be in the range of from about 0.5µm to about 1.5µm wide and from about 5µm to about 10µm long. Preferably, when the fuses are formed in parallel juxtaposition the distance between the fuses (fuse pitch) ranges from about 1µm to about 3µm.

A protective layer 15a is formed over a first portion 14a of fuse 10a. Protective layers 15b and 15c are formed over portions 14b and 14c, respectively of fuses 10b and 10c. This leaves portions 12a, 12b and 12c unprotected from laser energy impinging on the device. Protective layers 15a, b and c absorb and dissipate heat generated when the edge of a layer spot 20 impinges thereon, thereby protecting the fuses positioned below each respective protective layer. The protective layers 15a, b and c can be formed from any material that is substantially impervious to impinging laser energy that is strong enough to blow unprotected portions 12a, b or c. Materials that are highly absorptive of laser energy are particularly useful. Suitable materials from which the protective layer 15a, b and c can be formed include conductive materials such as aluminum, copper, tungsten, etc. The protective layers can be formed using techniques known to those skilled in the art. For example, the protective layer can be deposited by sputter coating followed by patterning using known lithographic and etching techniques. The precise dimensions of the protective layer will depend on a number of factors including, but not limited to, the dimension and material of construction of the fuse being protected and the fuse being blown, and the type and energy of the laser being used to blow the fuses. Typically, however, the protective layer should be slightly wider than the fuse being protected and as thick as practically permissible. Normally the protective layer will range in thickness from about 0.1µm to about 2µm thick, preferably from about 1µm to about 2µm thick.

In a particularly useful embodiment shown in FIG. 2, the protective layer is formed over, but not directly in contact with the fuse. Rather, an intermediate layer 19 is formed on substrate 5 and over fuses 10a, b and c before deposition of the protective layer. Intermediate layer 19 is preferably made from a material that is relatively poor conductor of heat compared to the protective layer or fuse. Suitable materials include dielectric materials such as, for example, silicon oxide or silicon nitride. It is further contemplated that intermediate layer 19 can be composed of more than one layer of different materials. Generally, the thickness of intermediate layer 19 will range from about 0.2µm to about 1µm. Intermediate layer 19 provides insulative properties to help ensure that laser beam 20 that contacts, for example, protective layer 15c dissipates and is not directly transferred to portion 14c of fuse 10c. In this manner, inadvertent damage to fuse 10c is prevented. It should be noted that partial damage to protective layers 15a, b and c due to laser energy impinging thereon can be tolerated without any adverse effect on the device.

The protective layer described herein allows for fuses to be positioned in close proximity (decreased fuse pitch) and blown by laser energy without the risk of inadvertent damage to adjacent fuses. The device also allows for laser spot misalignment and high energy laser application thus increasing the reliability and speed of the fuse cut process, thereby providing superior process control.

Although the present invention has been described in preferred forms with a certain degree of particularity, many changes and variations are possible therein and will be apparent to those skilled in the art after reading the foregoing description. It is therefore to be understood that the present invention may be practiced otherwise than as specifically described herein without departing from the spirit and scope thereof.

## Claims

1. An integrated circuit comprising:
a plurality of adjacent fuses, including a first fuse having a protective layer substantially impervious to laser energy positioned over at least a portion thereof such that, upon impingement of laser energy over at least the first fuse, the protective layer protects the portion of the first fuse covered thereby.

2. An integrated circuit as in claim 1 wherein at least two of the plurality of adjacent fuses are in parallel juxtaposition.

3. An integrated circuit as in claim 1 wherein the distance between the at least two fuses in parallel juxtaposition are spaced apart a distance from about 1µm to about 3µm.

4. An integrated circuit as in claim 1 wherein the plurality of fuses are made from one or more materials selected from the group consisting of Al, Cu, W, Ti, TiN and alloys thereof.

5. An integrated circuit as in claim 1 wherein the protective layer is made from one or more materials selected from the group consisting of aluminum, copper and tungsten.

6. An integrated circuit as in claim 1 further comprising an intermediate layer formed between the first fuse and the protective layer.

7. An integrated circuit as in claim 6 wherein the intermediate layer is made at least in part from one or more materials selected from the group consisting of silicon oxide and silicon nitride.

8. An integrated circuit comprising:
a first fuse having a first portion;
a second fuse having a first portion and a second portion, the first portion of the second fuse being positioned adjacent the first portion of the first fuse; and
a protective layer associated with the first portion of the second fuse,
whereby the first portion of the second fuse remains intact upon exposure of the first portion of the first fuse to sufficient laser energy to blow the first portion of the first fuse.

9. An integrated circuit as in claim 8 wherein the first and second fuses are in parallel juxtaposition.

10. An integrated circuit as in claim 9 wherein the distance between the first and second fuses are spaced apart a distance from about 1µm to about 3µm.

11. An integrated circuit as in claim 8 wherein the first and second fuses are each independently made from one or more materials selected from the group consisting of Al, Cu, W, Ti, TiN and alloys thereof.

12. An integrated circuit as in claim 8 wherein the protective layer is made from one or more materials selected from the group consisting of aluminum, copper and tungsten.

13. An integrated circuit as in claim 8 further comprising an intermediate layer formed between the second fuse and the protective layer.

14. An integrated circuit as in claim 13 wherein the intermediate layer is made at least in part from one or more materials selected from the group consisting of silicon oxide and silicon nitride.

15. A method of making an integrated circuit comprising:
a) forming a first interconnect and a second interconnect on a substrate;
b) forming a protective layer over a portion of the first interconnect;
c) exposing a portion of the integrated circuit that includes the first interconnect to laser energy sufficient to vaporize a portion thereof, the second interconnect being protected by the protective layer from damage by the laser energy.

16. A method as in claim 15 further comprising forming an intermediate layer between the first interconnect and the protective layer.

17. A method as in claim 15 further comprising forming a protective layer over the second interconnect.

18. A method as in claim 15 wherein step a) comprises forming the first and second interconnects in parallel juxtaposition.

19. A method as in claim 18 wherein the first and second interconnects are separated by a distance varying from about 1µm to about 3µm.
